# EUROPEAN PATENT APPLICATION

(11) **EP 4 633 315 A1**
(43) Date of publication of application: **15.10.2025**
(21) Application number: 23900433.6
(22) Date of filing: 17.11.2023
(51) Int. Cl.: H05K 9/00, B32B 7/025

(54) **MAGNETIC SHEET AND MAGNETIC SHEET STRUCTURE COMPRISING SAME**

(30) Priority: 07.12.2022 JP 2022195296
(71) Applicant: Toda Kogyo Corp., Hiroshima-shi, Hiroshima 732-0828 (JP)
(72) Inventor: OHMAE Satoshi, Otake-shi, Hiroshima 739-0652 (JP); KIMURA Tetsuya, Otake-shi, Hiroshima 739-0652 (JP); OHASHI Akihiro, Otake-shi, Hiroshima 739-0652 (JP)
(74) Representative: Schiweck Weinzierl Koch Patentanwälte Partnerschaft mbB
(86) International application number: PCT/JP2023/041417
(87) International publication number: WO 2024/122312

(57) **Abstract**

A magnetic sheet (1) comprises a magnetic plate (10) having a dimension that allows for wrapping around an outer periphery of cables (2) at least once without interruption; a protective layer (20) provided on a surface of the magnetic plate (10); and an adhesive layer (30) provided on a surface of the magnetic plate (10) opposite to the protective layer (20). The protective layer (20) and the adhesive layer (30) have a greater dimension than the magnetic plate (10), and are formed to enable wrapping such that when the magnetic sheet (1) is wrapped around the outer periphery of the cables (2) with the adhesive layer (30) facing toward the cables (2), a portion of the adhesive layer (30) adheres to a surface of the protective layer (20) opposite to the magnetic plate (10).

## Description

### TECHNICAL FIELD

The present disclosure relates to a magnetic sheet for wrapping around an outer periphery of an article, and a magnetic sheet structure using the magnetic sheet.

### BACKGROUND ART

In recent years, there is ongoing development to supply increased currents through cables mounted on the vehicle body of electric and hybrid vehicles. On the other hand, there is an increasing problem with electromagnetic noise generated from the cables. Since interfering with other electronic devices and causing, for example, malfunctions and breakdowns, electromagnetic noise is of increasing concern as demand for autonomous driving expands. Therefore, measures to suppress electromagnetic noise are needed, and as the measures, a magnetic sheet including a sheet-shaped magnetic material is wrapped around, and fixed to, an article, such as a cable, which is a source of electromagnetic noise, to suppress electromagnetic noise.

As a method for fixing such magnetic sheet to an article, for example, Patent Literature 1 discloses a method for fixing the magnetic sheet to the article using rivets or cloth tape. Particularly, Patent Literature 1 describes wrapping a tape-shaped shielding material formed from a magnetic body around an article in a spiraling and overlapping manner, and then fastening and fixing the overlapping portions using rivets, or fixing the shielding material from the outside using cloth tape. This is considered to allow for a good wrapping state of the magnetic sheet around the article.

Additionally, Patent Literature 2 discloses a method of fixing to an article a one-sided adhesive sheet having a pair of ferrite sintered bodies affixed to it, by wrapping the one-sided adhesive sheet around the article and overlapping one end of the one-sided adhesive sheet on the other end (see FIG. 5 of Patent Literature 2).

### CITATION LIST

### PATENT LITERATURE

[Patent Literature 1] Japanese Laid-Open Patent Publication No. H09-214166
[Patent Literature 2] Japanese Laid-Open Patent Publication No. 2009-212419

### SUMMARY OF INVENTION

### TECHNICAL PROBLEM

In the case of the method for fixing using additional members, such as rivets or cloth tape, in Patent Literature 1, the wrapping state of the magnetic sheet around the article can be quite good as described above. In this respect, in the method of Patent Literature 1, further fixing using additional members is necessary after wrapping the magnetic sheet, thus increasing work steps and reducing productivity. In addition, in the case of fixing using, for example, cloth tape, the magnetic sheet may peel off from the article due to insufficient adhesion, thus reducing its effects in suppressing electromagnetic noise.

In the method of fixing such that an adhesive surface of the one end of the one-sided adhesive sheet overlaps on the other end, as disclosed in Patent Literature 2, additional members are not necessary and the workability can be improved. In this regard, in the method of Patent Literature 2, the pair of ferrite sintered bodies are only provided on respective front and back sides of flat cables serving as the article, i.e., are configured to sandwich from the front and back sides, in the state where the magnetic sheet is wrapped around the flat cables. Therefore, electromagnetic noise may be leaked from portions lacking the ferrite sintered body and it may not be possible to ensure excellent noise suppression effects of the magnetic sheet.

The present disclosure is made in view of the foregoing problems, and an object of the present disclosure is to facilitate the workability of wrapping a magnetic sheet around an article, exhibit uninterrupted noise suppression effects around an outer periphery of the article, and mitigate the reduced noise suppression effect caused by the magnetic sheet having peeled off from the article after wrapping the magnetic sheet around the article.

### SOLUTION TO PROBLEM

To achieve the object, a magnetic sheet of the present disclosure includes a magnetic plate having a dimension that allows for wrapping around an outer periphery of an article at least once without interruption, and is configured to be less susceptible to peeling of the magnetic sheet from the article after wrapping the magnetic sheet around the article.

Specifically, the magnetic sheet of the present disclosure is a magnetic sheet for wrapping around an outer periphery of an article, comprising: a magnetic plate having a dimension that allows for wrapping around the outer periphery of the article at least once without interruption; a protective layer having a greater dimension than the magnetic plate and provided to cover a surface of the magnetic plate; and an adhesive layer having a greater dimension than the magnetic plate and provided on a surface of the magnetic plate opposite to the protective layer, wherein the protective layer and the adhesive layer are formed to enable wrapping such that when the magnetic sheet is wrapped around the outer periphery of the article with the adhesive layer facing toward the article, a portion of the adhesive layer adheres to a surface of the protective layer opposite to the magnetic plate.

In the magnetic sheet according to the present disclosure, the magnetic sheet can be directly affixed to the article via the adhesive layer provided on the magnetic plate, so that additional members, such as cloth tape for fixing, are not necessary and the workability of wrapping the magnetic sheet around the article can be improved. Also, in the magnetic sheet according to the present disclosure, the magnetic plate has a length that allows for wrapping around the outer periphery of the article at least once without interruption, so that when the magnetic sheet is wrapped around the outer periphery of the article with the adhesive layer facing toward the article, the magnetic plate can cover the outer periphery of the article once. This reduces the leakage of electromagnetic noise from the article, thus ensuring excellent noise suppression effects of the magnetic sheet. Further, the protective layer and the adhesive layer are configured to enable wrapping such that the portion of the adhesive layer adheres to the surface of the protective layer opposite to the magnetic plate, when the magnetic sheet is wrapped around the outer periphery of the article. Thus, after wrapping the magnetic plate and the protective layer around the outer periphery of the article at least once, the protective layer is further wrapped over the outer periphery surface via the adhesive layer. This enables reliable fixing of the magnetic sheet to the outer periphery of the article, and as a result, the reduced noise suppression effect caused by the magnetic sheet having peeled off from the article after wrapping the magnetic sheet around the article can be mitigated. Therefore, the magnetic sheet according to the present disclosure can facilitate the workability of wrapping the magnetic sheet around the article, and mitigate reduced noise suppression effects caused by the magnetic sheet peeled off from the article, for example.

In the magnetic sheet according to the present disclosure, an area including the magnetic plate is positioned to be sandwiched between areas lacking the magnetic plate in a direction of wrapping the magnetic sheet, and one of the areas lacking the magnetic plate preferably has a dimension that allows for wrapping around an outer periphery of the area including the magnetic plate, at least once, without interruption, when the magnetic sheet is wrapped around the outer periphery of the article with the adhesive layer facing toward the article.

In this way, after wrapping the magnetic plate and the protective layer around the outer periphery of the article via the adhesive layer at least once without interruption, the protective layer is further wrapped over the outer periphery surface via the adhesive layer at least once without interruption, so that the magnetic sheet can be more firmly fixed to the article.

The magnetic sheet according to the present disclosure may be a magnetic sheet formed in a belt shape.

Another aspect of the present disclosure is a magnetic sheet structure comprising an article, and a magnetic sheet according to any of those described above, wherein the magnetic sheet is wrapped around an outer periphery of the article such that the adhesive layer is wrapped to face toward the article, and a portion of the adhesive layer adheres to a surface of the protective layer opposite to the magnetic plate.

Since such magnetic sheet structure includes the magnetic sheet of the present disclosure as described above, the magnetic sheet structure can facilitate the workability of wrapping the magnetic sheet around the article, and cover the outer periphery of the article with the magnetic plate once, and further prevent the magnetic sheet from peeling off from the article after wrapping the magnetic sheet around the article, thus ensuring excellent noise suppression effects.

### ADVANTAGEOUS EFFECTS OF INVENTION

The magnetic sheet of the present disclosure can facilitate the workability of wrapping the magnetic sheet around the article, exhibit uninterrupted noise suppression effects around the outer periphery of the article, and mitigate the reduced noise suppression effect caused by the magnetic sheet having peeled off from the article after wrapping the magnetic sheet around the article.

### BRIEF DESCRIPTION OF DRAWINGS

[FIG. 1] FIG. 1 is a plan view illustrating a magnetic sheet according to an embodiment of the present disclosure.
[FIG. 2] FIG. 2 is a cross-sectional view taken along line II-II in FIG.1, illustrating the magnetic sheet according to the embodiment of the present disclosure.
[FIG. 3] FIG. 3 is a perspective view illustrating an aspect of use for the magnetic sheet according to the embodiment of the present disclosure.
[FIG. 4] FIG. 4 is a cross-sectional view taken along line IV-IV in FIG.3, illustrating the aspect of use for the magnetic sheet according to the embodiment of the present disclosure.

### DETAILED DESCRIPTION

Embodiments of the present disclosure are described below with reference to the drawings. The following description of preferred embodiments is merely an example in nature, and is not intended to limit the present disclosure, methods of applying the present disclosure, or use of the present disclosure.

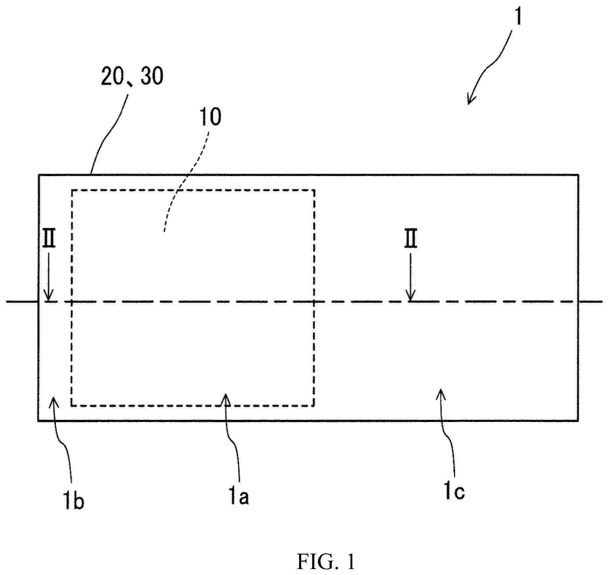

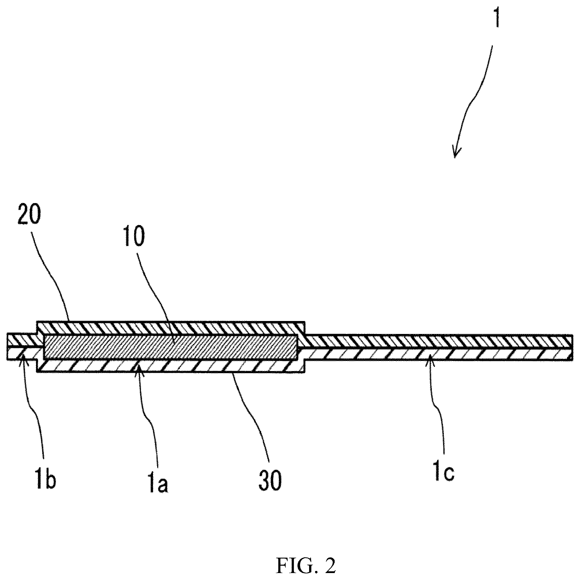

A magnetic sheet 1 according to an embodiment of the present disclosure is first described with reference to FIGs. 1 and 2. FIG. 1 is a plan view of the magnetic sheet 1 and FIG. 2 is a cross-sectional view taken along line II-II in FIG. 1. As shown in FIGs. 1 and 2, the magnetic sheet 1 according to the embodiment includes a magnetic plate 10, a protective layer 20 provided on a surface of the magnetic plate 10, and an adhesive layer 30 provided on a surface of the magnetic plate 10 opposite to the protective layer 20. The magnetic plate 10 has, as described below, a dimension that, when the magnetic sheet 1 is wrapped around an article, allows for wrapping around an outer periphery of the article at least once without interruption. The protective layer 20 and the adhesive layer 30 have a greater dimension than the magnetic plate 10, and are particularly formed, as described below, to enable wrapping such that when the magnetic sheet 1 is wrapped around the article, a portion of the adhesive layer 30 adheres to a surface of the protective layer 20 opposite to the magnetic plate 10. Also, since the protective layer 20 and the adhesive layer 30 have a greater dimension than the magnetic plate 10, the magnetic sheet 1 has a structure where an area 1a including the magnetic plate 10 is sandwiched between areas 1b, 1c lacking the magnetic plate 10 in its longitudinal direction. One area 1b lacking the magnetic plate 10 is shorter than the other area 1c, and the other area 1c preferably has a length equal to or more than the area 1a including the magnetic plate 10. Also, the magnetic plate 10 (the area 1a including the magnetic plate 10) in the magnetic sheet 1 has a length that allows for wrapping around the outer periphery of the article at least once without interruption, as described above. In FIG.1, the shape of the magnetic sheet 1 is shown as a belt shape; however, the embodiment is not limited to this configuration and it may be a circular sector shape or trapezoidal shape. Moreover, the width and thickness of the magnetic sheet 1 are not particularly limited, and the length is also not limited as long as the above conditions are satisfied, and can be appropriately adjusted based on the outer diameter of the article and the size of the region to be wrapped, for example.

The magnetic plate 10 is formed such that a sintered body made from a magnetic material, or a formed body made from a mixture of magnetic material powder and resin, is shaped into a plate shape. Types of the magnetic material used are not particularly limited as long as it has magnetic properties; however, for example, spinel ferrite such as Ni-Zn-based ferrite and Mn-Zn-based ferrite, hexagonal ferrite such as Ba-based ferrite, soft magnetic metals such as iron and iron-based alloy can be used. Methods for producing the magnetic plate 10 are not particularly limited as well; however, when the sintered body made from a magnetic material is used, a method including coating a plastic film with a ferrite-dispersed coating material to provide a ferrite formed sheet and firing it to provide a ferrite sintered body can be used, for example.

When such ferrite sintered body is used as the magnetic plate 10, the ferrite sintered body may be previously split into small pieces in the magnetic sheet 1 in order to facilitate wrapping of the magnetic sheet 1 around the article. Predetermined splitting grooves may be formed in the ferrite formed sheet in order to split the ferrite sintered body into small pieces. The splitting grooves may be either continuous or intermittent, and may also be instead formed in a form of many fine recesses. The magnetic plate 10 is split into triangular, quadrilateral, polygonal shapes of any size, or shapes obtained by combining thereof, by using the preformed splitting grooves. A split into irregular shapes may be also performed without forming the splitting grooves.

Materials of the protective layer 20 are not particularly limited as long as the material is a resin expandable and contractible without breaking when the magnetic sheet 1 is wrapped around the article; however, for example, a resin material, such as polyethylene terephthalate (PET) can be used. The protective layer 20 may be adhered to the magnetic plate 10 via an adhesive material (not shown), such as double sided tape, or the protective layer 20 as such may be, for example, resin tape including an adhesive material.

The adhesive layer 30 is not particularly limited as long as the magnetic plate 10 can be adhered to the article; however, for example, double sided tape, for which an adhesive material is provided on both faces of a resin substrate, such as PET, can be used. For the substrate, for example, polyimide, urethane resin, acrylic resin, paper, silicone, polyvinyl chloride resin, other than PET, can be used. For the adhesive material, for example, acrylic-based adhesive material, chemical resistant adhesive material, heat resistant adhesive material, hot-melt adhesive material can be used.

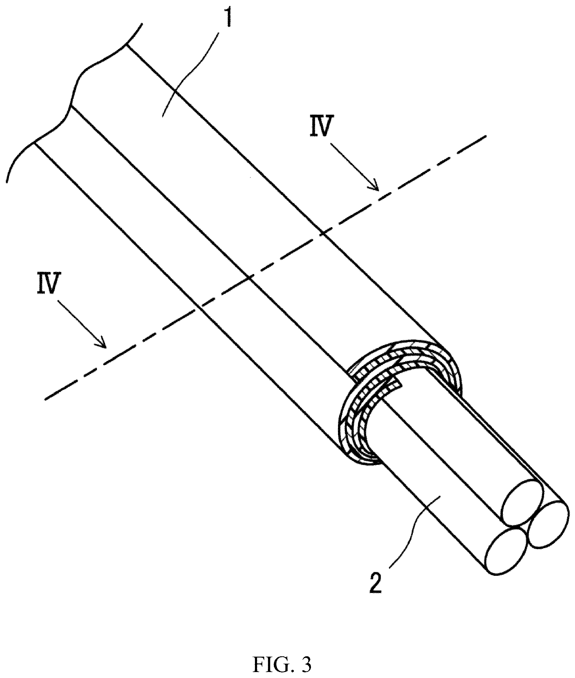

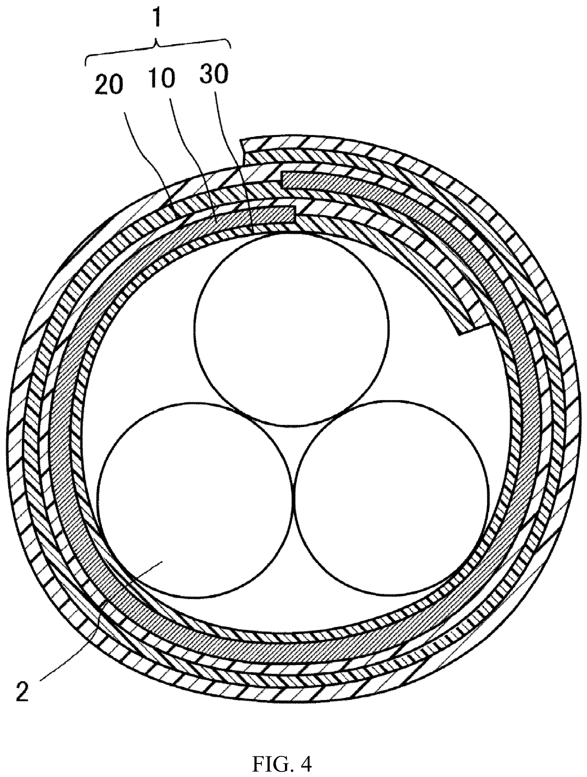

Next, the magnetic sheet 1 according to the embodiment of the present disclosure is further described in detail with reference to FIGs. 3 and 4. FIG. 3 is a perspective view showing a state where the magnetic sheet 1 is wrapped around cables 2 serving as an article and FIG. 4 is a cross-sectional view taken along line IV-IV in FIG. 3. As shown in FIGs. 3 and 4, the magnetic sheet 1 is wrapped around an outer periphery of cables 2 with the adhesive layer 30 facing toward the cables 2. Specifically, the shorter length area 1b lacking the magnetic plate 10 in magnetic sheet 1 is first affixed to the cables 2, and by using this as a starting point, the magnetic sheet 1 is wrapped around the outer periphery of the cables 2. Thus, the area 1c lacking the magnetic plate 10 is wrapped around an outer periphery of the area 1a including the magnetic plate 10 in an overlapping manner. In the embodiment, the article is shown as three cables 2; however, the number and outer diameter of the cables 2 are not particularly limited. Methods for wrapping the magnetic sheet 1 around the outer periphery of the cables 2 are also not particularly limited and for example, the magnetic sheet 1 may be wrapped continuously in a spiraling manner along an axial direction of the cable 2. The area 1b lacking the magnetic plate 10 in magnetic sheet 1 is used as the starting point for wrapping the magnetic sheet 1 around the cables 2, as described above, and preferably has a length ranging from one sixth to one fifth of the outer periphery of the cables 2. Particularly, in the embodiment, it has a length ranging from one sixth to one fifth of the length of the magnetic plate 10.

As shown in FIGs. 3 and 4, when the magnetic sheet 1 is wrapped around the outer periphery of the cables 2, the magnetic plate 10 has, as described above, a length that allows for wrapping around the outer periphery of the article at least once without interruption and thus, the magnetic plate 10 and the protective layer 20 are wrapped around the outer periphery of the cables 2 once without interruption via the adhesive layer 30. This reduces the leakage of electromagnetic noise from the cables 2 so that the electromagnetic noise generated from the cables 2 can be effectively suppressed. Further, the portion of the adhesive layer 30 is wrapped to adhere to the surface of the protective layer 20 opposite to the magnetic plate 10. Specifically, in the state where the magnetic plate 10 and the protective layer 20 are wrapped around the outer periphery of the cables 2, a portion of the protective layer 20 (the area 1c lacking the magnetic plate 10) is further wrapped over the outer periphery surface via adhesive layer 30. This enables reliable fixing of the magnetic sheet 1 to the outer periphery of the cables 2, so that the reduced noise suppression effect caused by the magnetic sheet 1 having peeled off from the cables 2 after wrapping the magnetic sheet 1 around the cables 2 can be mitigated. To prevent the peeling to a greater extent, the area 1c lacking the magnetic plate 10 preferably has a length that allows for wrapping around an outer periphery of the magnetic plate 10 (the area 1a including the magnetic plate 10) once or more. In the embodiment, the magnetic plate 10 is wrapped around the outer periphery of the cables 2 once; however, the embodiment is not limited to this configuration and it may be wrapped around the outer periphery of the cables 2 at least once or more without interruption. Also, the protective layer 20 is provided to cover the surface of the magnetic plate 10, so that damage to the magnetic plate 10 caused by contacting the magnetic sheet 1 with peripheral members can be prevented. Also, when the ferrite sintered body is used as the magnetic plate 10 as described above, the protective layer 20 provided to cover the surface of the magnetic plate 10 can prevent the small pieces of the ferrite sintered body from falling off the protective layer 20, and also can mitigate damage to peripheral members caused by the hard ferrite sintered body that is exposed from the protective layer 20.

As described above, in the magnetic sheet 1 according to the embodiment, the magnetic plate 10 has a dimension that allows for wrapping around the outer periphery of the article at least once without interruption as described above, and thus can be wrapped around the outer periphery of the cables 2 once without interruption, so that excellent noise suppression effects can be ensured. Further, after wrapping the magnetic plate 10 around the outer periphery of the cables 2 at least once, the portion of protective layer 20 (the area 1c lacking the magnetic plate 10) is wrapped via the adhesive layer 30, so that the magnetic sheet 1 can be reliably fixed to the outer periphery or the cables 2. This can mitigate the reduced noise suppression effect caused by the magnetic sheet 1 having peeled off from the cables 2 after wrapping the magnetic sheet 1 around the cables 2. Therefore, the magnetic sheet 1 according to the embodiment can facilitate the workability of wrapping the magnetic sheet 1 around the cables 2, exhibit uninterrupted noise suppression effects around the outer periphery of the article, and mitigate the reduced noise suppression effect caused by the magnetic sheet 1 peeled off from the cables 2.

Another embodiment of the present disclosure is directed to a magnetic sheet structure comprising an article, and a magnetic sheet as described above, in which the magnetic sheet is wrapped around an outer periphery of the article such that an adhesive layer is wrapped to face toward the article, and a portion of the adhesive layer adheres to a surface of a protective layer opposite to a magnetic plate. The magnetic sheet structure can cover the outer periphery of the article with the magnetic plate once, and further prevent the magnetic sheet from peeling off from the article after wrapping the magnetic sheet around the of the article, thus ensuring excellent noise suppression effects.

In the embodiments, the cables are used and described as an example for the article; however, the present disclosure is not limited to the configuration and for example, can be applied to electronic devices and non-contact power supply devices such as RFID.

### DESCRIPTION OF REFERENCE CHARACTERS

- 1: Magnetic sheet
- 2: Cable
- 10: Magnetic plate
- 20: Protective layer
- 30: Adhesive layer

## Claims

1. A magnetic sheet for wrapping around an outer periphery of an article, comprising:
a magnetic plate having a dimension that allows for wrapping around the outer periphery of the article at least once without interruption;
a protective layer having a greater dimension than the magnetic plate and provided to cover a surface of the magnetic plate; and
an adhesive layer having a greater dimension than the magnetic plate and provided on a surface of the magnetic plate opposite to the protective layer,
wherein the protective layer and the adhesive layer are formed to enable wrapping such that when the magnetic sheet is wrapped around the outer periphery of the article with the adhesive layer facing toward the article, a portion of the adhesive layer adheres to a surface of the protective layer opposite to the magnetic plate.

2. The magnetic sheet according to claim 1, wherein an area including the magnetic plate is positioned to be sandwiched between areas lacking the magnetic plate in a direction of wrapping the magnetic sheet, and
one of the areas lacking the magnetic plate has a dimension that allows for wrapping around an outer periphery of the area including the magnetic plate, at least once, without interruption, when the magnetic sheet is wrapped around the outer periphery of the article with the adhesive layer facing toward the article.

3. The magnetic sheet according to claim 1 or 2, wherein the magnetic sheet is formed in a belt shape.

4. A magnetic sheet structure comprising an article, and a magnetic sheet according to claim 1 or 2,
wherein the magnetic sheet is wrapped around an outer periphery of the article such that the adhesive layer is wrapped to face toward the article, and a portion of the adhesive layer adheres to a surface of the protective layer opposite to the magnetic plate.
